# EUROPEAN PATENT APPLICATION

(11) **EP 1 727 144 A1**
(43) Date of publication of application: **29.11.2006**
(21) Application number: 05252773.6
(22) Date of filing: 05.05.2005
(51) Int. Cl.: G11B 27/10, G11B 27/34

(54) **Method for a continuous repeat segment playback of an electronic file**

(71) Applicant: Tatung Co., Ltd., Taipei City 104, R.O.C. (TW)
(72) Inventor: Chen, Yi-Ru, Jhongshan District Taipei City 104 (TW); Chen, Chun-Ru, Jhongshan District Taipei City 104 (TW); Chan, Chieh-Yu, Jhongshan District Taipei City 104 (TW); Hsu, Guang-Min, Jhongshan District Taipei City 104 (TW)
(74) Representative: Tranter, Andrew David

(57) **Abstract**

A method of a continuous repeat segment playback of an electronic file that can be utilized on a portable electronic device is presented. The method of a continuous repeat segment playback includes: recalling a setup interface; inputting a repeat segment starting time; inputting a repeat segment ending time; beginning a playback of an electronic file at the inputted starting time and stopping the playback of the electronic file at the inputted ending time; and recalling the setup interface and identifying whether the repeat segment of the electronic file shall be continuously played. If it fails to hold, then the playback of the MP3 file is discontinued; such identifying procedure ensures that while the portable electronic device is executing the repeat segment playback of an electronic file, the file can still be continuously played in case the user exits such mode.

## Description

### BACKGROUND OF THE INVENTION

### 1. Field of the Invention

The present invention relates to a method for a continuous repeat segment playback of an electronic file and more particularly, to a method for a continuous repeat segment playback of an electronic file that can be utilized on a portable electronic device.

### 2. Description of Related Art

Due to the prevalence of the digital electronics technology, nowadays a variety of portable electronic devices, such as VCD, DVD, MP3 players, and PDA, not only feature mobility and modem designs, but also possess multiple functions, such as the repeat segment playback function, the single file playback function, the audio or video recording function, etc. However, some of those functions are not adequately practical to satisfy consumers' demands. Even though nowadays most of the portable devices, for example, feature the repeat segment playback function, such function would be automatically terminated when the users exit the corresponding mode. To extend the practicality of the repeat segment playback function, allowing the users to be able to recall or cancel such function under any mode, an improvement seems necessary.

### SUMMARY OF THE INVENTION

The present invention discloses a method for a continuous repeat segment playback of an electronic file that can be utilized on a portable electronic device, which can be an MP3 player, an electronic language-learning device, or a CD player. The method comprises the steps of: (A) recalling a setup interface; (B) inputting a repeat segment starting time; (C) inputting a repeat segment ending time; (D) beginning the playback of an electronic file at the starting time as previously inputted and stopping the playback of the electronic file at the ending time as previously inputted; and (E) recalling the aforementioned setup interface and identifying whether to continuously play the repeat segment of the electronic file; if not then playback of the electronic file is discontinued.

Also a status bar, including a time indicator display and a status indicator display, is displayed on the bottom portion of any user interface, in which it indicates to the users whether the repeat segment of the electronic file is continuously being played at the moment.

Thus the method mentioned above is intended for specific circumstances, as when the portable electronic device is executing a repeat segment playback of an electronic file, the portable electronic device will not automatically terminate such playback function in case the user accidentally exits the corresponding mode.

### BRIEF DESCRIPTION OF THE DRAWINGS

FIG. 1 is a flowchart of the method according to the present invention.
FIG. 2 is a functional diagram showing the preferred embodiment of the present invention.

### DETAILED DESCRIPTION OF THE PREFERRED EMBODIMENT

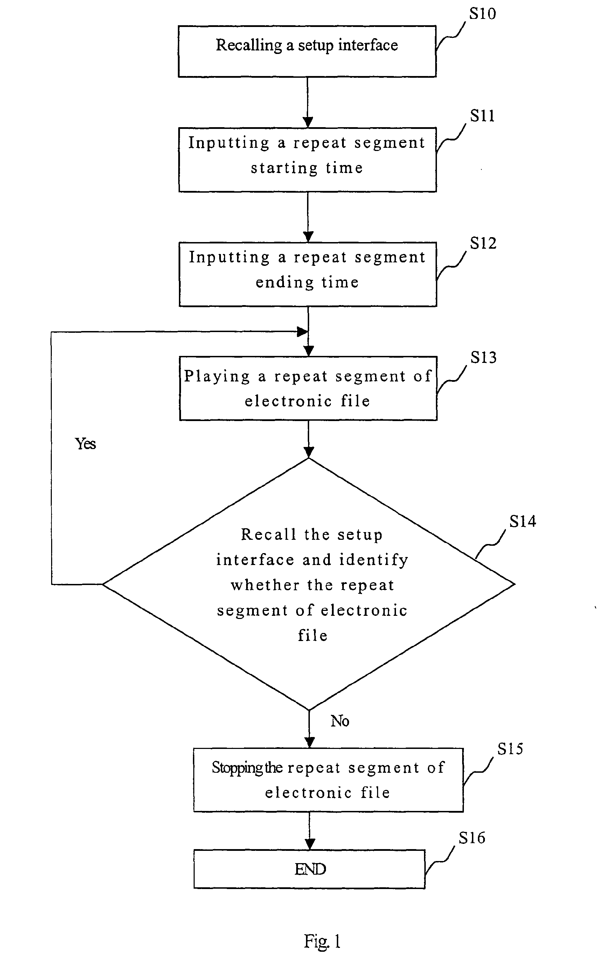

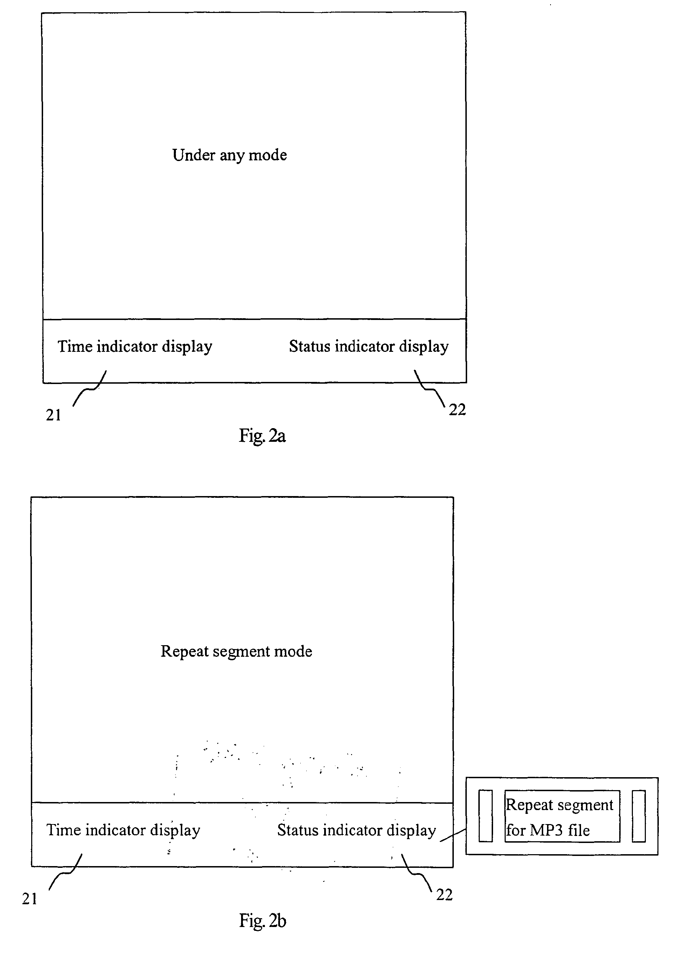

Please refer to both FIG. 1, the flowchart illustrating the method for a continuous repeat segment playback of an electronic file according to the present invention, and FIG. 2, the functional diagram showing the preferred embodiment of the present invention. Under any mode, the user chooses to execute a repeat segment playback function by clicking one of the buttons on the control panel. The bottom left and the bottom right corners of every interface show a time indicator display 21 and a status indicator display 22 respectively as shown in FIG. 2a.

In step **S10** a setup interface for the repeat segment playback mode is first recalled, followed by the input of a repeat segment starting time (step **S11**) and a repeat segment ending time (step **S12**). After finishing inputting the starting and the ending time of the repeat segment, the electronic player plays the segment of the MP3 file from the previously inputted starting time up to the inputted ending time (step **S13),** meanwhile the status indicator display **22** on the bottom right corner shows the status of the MP3 file started being played in repeat segment as shown in FIG. 2b.

In step S 14, the aforementioned setup interface for repeat segment playback is recalled, identifying whether the repeat segment playback of the MP3 file shall be continued. If the repeat segment playback from the aforementioned setup interface fails to hold, then the playback of the MP3 file is terminated; otherwise the electronic player continues the repeat segment playback of the MP3 from the inputted starting time up to the inputted ending time.

According to the method as mentioned above in this embodiment, when the electronic player is executing a repeat segment of the MP3 file, the user is allowed to exit the corresponding mode for repeat segment playback whilst the MP3 file can still be played continuously in repeat segment without interruption. If the user would like to discontinue such repeat segment, steps **S14, S15,** and **S16** are to be followed in numerical sequence.
Although the present invention has been explained in relation to its preferred embodiment, it is to be understood that many other possible modifications and variations can be made without departing from the spirit and scope of the invention as hereinafter claimed.

## Claims

1. A method for a continuous repeat segment playback of an electronic file utilized on a portable electronic device comprising the steps of:
(A) recalling a setup interface;
(B) inputting a repeat segment starting time;
(C) inputting a repeat segment ending time;
(D) beginning a playback of an electronic file at said starting time and stopping the playback of said electronic file at said ending time; and
(E) recalling said setup interface and identifying whether the repeat segment of said electronic file shall be continuously played; if not then discontinuing the playback of said electronic file.

2. The method as claimed in claim 1, wherein said portable electronic device is an MP3 player, an electronic language-learning device, or a Compact Disc player.
